# EUROPEAN PATENT APPLICATION

(11) **EP 1 557 880 A1**
(43) Date of publication of application: **27.07.2005**
(21) Application number: 05000896.0
(22) Date of filing: 18.01.2005
(51) Int. Cl.: H01L 23/29, H01L 21/56

(54) **Resin composition for encapsulating semiconductor**

(30) Priority: 21.01.2004 JP 2004013396; 21.01.2004 JP 2004013405
(71) Applicant: Nitto Denko Corporation, Ibaraki-shi, Osaka 567-8680 (JP)
(72) Inventor: Noro, Hiroshi, Ibaraki-shi Osaka (JP)
(74) Representative: HOFFMANN - EITLE

(57) **Abstract**

A resin composition usable for encapsulating a semiconductor, wherein the resin composition has a viscosity of 5000 Pa•s or less as determined at 80°C, and wherein the resin composition comprises (A) an epoxy resin having two or more epoxy groups in one molecule; (B) a curing agent; and (C) silica particles having an average particle diameter dmax of from 3 to 50 nm and a half-width of 1.5 times or less of the average particle diameter dmax; a sheet-like resin composition usable for encapsulating a semiconductor, wherein the sheet-like resin composition has a viscosity of 10000 Pa•s or less as determined at 80°C, and wherein said sheet-like resin composition comprises (A) an epoxy resin having two or more epoxy groups in one molecule; (B) a curing agent; and (C) silica particles having an average particle diameter dmax of from 3 to 50 nm and a half-width of 1.5 times or less of the average particle diameter dmax; and a semiconductor device manufactured by encapsulating a semiconductor with the resin composition as defined above. The resin composition for encapsulating a semiconductor can be utilized in encapsulating a gap formed between a printed circuit board and a semiconductor element in the semiconductor industries.

## Description

### BACKGROUND OF THE INVENTION

### Field of the Invention

The present invention relates to a resin composition for encapsulating a semiconductor (which may be hereinafter also simply referred to as a "resin composition" in some cases) for encapsulating a gap formed between a printed circuit board and a semiconductor element in a semiconductor device, and to a semiconductor device manufactured by encapsulating a semiconductor with the resin composition.

### Discussion of the Related Art

As the recent requirements accompanied by multi-functionality and miniaturization of a semiconductor device, a flip-chip mounting in which a semiconductor element is mounted on a printed circuit board with a facedown structure has been carried out. Generally, in the flip-chip mounting, a gap formed between a semiconductor element and a printed circuit board is encapsulated with a thermosetting resin composition in order to protect the semiconductor element.

In the flip-chip mounting system, the semiconductor elements and the printed circuit board which have different linear expansion coefficients are directly electrically connected, there arises a problem in the reliability in its connection portion.

As a countermeasure therefor, there has been employed a process for improving connection reliability comprising filling a liquid resin material into a gap formed between semiconductor elements and a printed circuit board, and curing the liquid resin material to form a resin-cured product, thereby dispersing stresses concentrated on the electric connection portion also to the above-mentioned resin-cured product. In a conventional process for filling a liquid material in a flip-chip mounting system using a solder bump, semiconductor elements are first mounted on a printed circuit board to form a metal junction by the step of solder melting, and thereafter injecting a liquid resin material into a gap formed between semiconductor elements and a printed circuit board by a capillary phenomenon (for example, refer to JP2001-279058A).

Further, in recent years, the manufacture of the above-mentioned semiconductor devices using a thermosetting resin composition having solderability has been proposed, the manufacture which attempts to further simplify the processes than the method for injecting a liquid material utilizing a capillary phenomenon (for instance, refer to JP2000-120360A). In this manufacture of semiconductor devices using a thermosetting resin composition having solderability, the thermosetting resin composition is first applied to semiconductor elements or a printed circuit board to carry out interfacial encapsulation together with chip mounting, and thereafter the printed circuit board with chips is subjected to solder reflow to form metal junction. Therefore, the steps such as application and washing of flux and injection of a liquid resin can be omitted, as compared to the manufacture of semiconductor devices using the above-mentioned liquid resin material, whereby the productivity of semiconductor devices can be improved.

In addition, a conventional manufacturing method with the flip-chip mounting comprises the step of creating patterns on a wafer, forming bumps on the wafer, cutting the wafer into individual semiconductor elements, mounting the semiconductor elements on a printed circuit board, and carrying out resin encapsulation. On the other hand, in order to improve the productivity of semiconductor devices, there has been desired a method comprising the steps of creating patterns on a wafer, forming bumps on the wafer, feeding an adhesive (resin composition) to a patterned side, cutting the wafer into individual semiconductor elements, and mounting the semiconductor element on a printed circuit board in a face-down structure (hereinafter referred to as wafer level flip-chip mounting method) (see, for instance, JP2001-144120A). In the wafer level flip-chip mounting method mentioned above, since a thermosetting resin composition is fed to a patterned side, the wafer is cut into individual semiconductor elements, and the semiconductor elements obtained are mounted in a printed circuit board, it is necessary that the thermosetting resin composition retains a pattern-recognizable transmittance. On the other hand, in the thermosetting resin composition for encapsulating a connecting portion of the flip-chip package, generally, coefficient of linear thermal expansion or water absorption is lowered by containing an inorganic filler in an organic resin composition, thereby satisfying thermal cycle test performance and solder resistance of semiconductor devices (for instance, see JP2003-138100A).

### SUMMARY OF THE INVENTION

The present invention pertains to:
[1] a resin composition usable for encapsulating a semiconductor, wherein the resin composition has a viscosity of 5000 Pa•s or less as determined at 80°C, and wherein the resin composition comprises:
   (A) an epoxy resin having two or more epoxy groups in one molecule;
   (B) a curing agent; and
   (C) silica particles having an average particle diameter dmax of from 3 to 50 nm and a half-width of 1.5 times or less of the average particle diameter dmax;
[2] a sheet-like resin composition usable for encapsulating a semiconductor, wherein the sheet-like resin composition has a viscosity of 10000 Pa•s or less as determined at 80°C, and wherein the sheet-like resin composition comprises:
   (A) an epoxy resin having two or more epoxy groups in one molecule;
   (B) a curing agent; and
   (C) silica particles having an average particle diameter dmax of from 3 to 50 nm and a half-width of 1.5 times or less of the average particle diameter dmax; and
[3] a semiconductor device manufactured by encapsulating a semiconductor with the resin composition as defined in the above [1] or [2].

### BRIEF DESCRIPTION OF THE DRAWINGS

Figure 1 is one example of a semiconductor device of the present invention;
Figure 2 is one example of an explanatory view of a step of the method for manufacturing a semiconductor device of the present invention;
Figure 3 is one example of an explanatory view of a step of the method for manufacturing a semiconductor device of the present invention;
Figure 4 is one example of a resin sheet containing the resin composition of the present invention;
Figure 5 is one example of a cross-sectional view of a wafer with bumps;
Figure 6 is one example of an explanatory view of a step of the method for manufacturing a semiconductor device of the present invention;
Figure 7 is one example of an explanatory view of a step of the method for manufacturing a semiconductor device of the present invention;
Figure 8 is one example of an explanatory view of a step of the method for manufacturing a semiconductor device of the present invention; and
Figure 9 is one example of an explanatory view of a step of the method for manufacturing a semiconductor device of the present invention.

The explanation of the numerals in the figures is as follows:

11 is a printed circuit board, 12 is a connecting electrode, 13 is a semiconductor element, 14 is an encapsulating resin layer, 15 is a resin composition for encapsulating a semiconductor, 21 is a resin composition for encapsulating a semiconductor, 22 is a stripping sheet, 23 is a wafer, 24 is a bump, 25 is a dicing tape, 26 is an individual chip, and 27 is a printed circuit board.

### DETAILED DESCRIPTION OF THE INVENTION

The present invention relates to a resin composition for encapsulating a semiconductor, which can be suitably used for flip-chip mounting, which is excellent in solderability and workability, thereby providing electric connection reliability after the resin encapsulation, and to a semiconductor device manufactured by encapsulation with the above composition.

The present invention also relates to a sheet-like resin composition for encapsulating a semiconductor, which can be suitably used for a wafer level flip-chip mounting, which retains pattern-recognizable transmittance, and is excellent in workability, thereby providing electric connection reliability after the resin encapsulation, and to a semiconductor device manufactured by encapsulation with the above composition.

According to the present invention, a resin composition for encapsulating a semiconductor, which is excellent in solderability and workability, is provided. In addition, since the composition is used, a semiconductor device having an excellent connection reliability can be efficiently manufactured.

Also, according to the present invention, a sheet-like resin composition for encapsulating a semiconductor, which retains pattern-recognizable transmittance, and is excellent in workability, is provided. In addition, since the composition is used, a semiconductor device having an excellent connection reliability can be efficiently manufactured.

These and other advantages of the present invention will be apparent from following description.

In the above-mentioned conventional manufacturing methods, a thermosetting resin composition is first applied to a semiconductor element or a printed circuit board, and thereafter soldering is carried out. Therefore, in the case where an inorganic filler such as silica is contained in the thermosetting resin composition, a sufficient solderability is not obtained because the inorganic filler sterically hinders on the surface of soldering. In addition, the mere containment of an inorganic filler having a smaller particle size in the resin composition so that the inorganic filler would not hinder the soldering would make the bulk density of the inorganic filler too high, whereby the compatibility with the resin composition is worsened, and its viscosity becomes too high so that the resin composition cannot be fed to a wafer.

Alternatively, in the case where silica is not contained in the thermosetting resin composition for the purpose of obtaining a sufficient solderability, the coefficient of linear thermal expansion of a resin composition is increased, various loads such as stresses generated by the difference in thermal expansion and shrinkage between the semiconductor elements and an encapsulating resin layer are applied on a connecting electrode. By repeated distortions generated by the load or the like, a connecting electrode is broken, leading to the breaking of a wire in the connecting electrode portion.

On the other hand, in the wafer level flip-chip mounting system, since a conventionally used inorganic filler has larger particle sizes than the wavelength of light in the visible region, it is difficult to retain pattern-recognizable transmittance in the resin composition containing the inorganic filler. In addition, in order to retain the pattern-recognizable transmittance, mere containment of the inorganic filler having smaller particle sizes in the resin composition would make the bulk density of the inorganic filler too high for the same reasons as mentioned above, so that arises problems that the compatibility of the filler with the resin composition is worsened, and that the viscosity becomes too high so that the resin composition cannot be fed to the wafer.

Alternatively, in order to retain the pattern-recognizable transmittance, when the content of the inorganic filler in the resin composition is lowered, the coefficient of linear thermal expansion or the water absorption of the resin composition is increased, whereby the resulting semiconductor device does not have sufficient thermal cycle test performance and solderability resistance.

### Embodiment 1

One of the great features of the resin composition for encapsulating a semiconductor of the present invention resides in that the resin composition has a viscosity of 5000 Pa•s or less as determined at 80°C, and that the resin composition comprises:
(A) an epoxy resin having two or more epoxy groups in one molecule;
(B) a curing agent; and
(C) silica particles having an average particle diameter dmax of from 3 to 50 nm and a half-width of 1.5 times or less of the average particle diameter dmax.

An inorganic filler such as silica particles is usually added to a resin composition used as a resin for encapsulation in the semiconductor device for the purpose of lowering coefficient of linear thermal expansion or water absorption thereof, thereby satisfying thermal stress reliability and solderability resistance of the semiconductor device. As described above, however, there arises a problem that a sufficient solderability cannot be obtained.

By contrast, since the resin composition of this embodiment contains silica particles having a specified particle diameter, there are exhibited some excellent effects that steric hindrance on the soldering surface can be avoided and that the stresses applied to a connecting electrode can be reduced when the gap between the printed circuit board and the semiconductor elements are encapsulated. Further, the semiconductor device manufactured by encapsulation with the resin composition of this embodiment has excellent property that excellent connection reliability is exhibited.

Each of the pair of terms "semiconductor circuit side" and "patterned side, terms "cutting" and "dicing," terms "connecting electrodes" and "bumps," and terms "chips," "semiconductor chips," and "semiconductor elements" as used herein are respectively used for the same meaning. Also, one obtained by heat-curing a resin composition of this embodiment as used herein is referred to as a cured product.

The epoxy resin having two or more epoxy groups in one molecule herein contained in the resin composition of this embodiment is not particularly limited as long as the epoxy resin is in a liquid state at a temperature of preferably at least 50°C. The epoxy resin includes, for instance, bisphenol A epoxy resins, bisphenol F epoxy resins, naphthalenic epoxy resins, alicyclic epoxy resins, and the like. Among them, the bisphenol A epoxy resins and the bisphenol F epoxy resins can be suitably used from the viewpoint of securing fluidity of the resin composition upon melting. These epoxy resins can be used alone or in admixture of two or more kinds.

The epoxy resin has an epoxy equivalence of preferably from 90 to 1000 g/eq., more preferably from 100 to 500 g/eq. It is preferable that the epoxy resin has an epoxy equivalence of 90 g/eq. or more in order that the cured product is less likely to be brittle, and that the epoxy resin has an epoxy equivalence of 1000 g/eq. or less in order that the glass transition temperature (Tg) of the cured product would not become too low. The content of the epoxy resin in the resin composition is preferably from 5 to 90% by weight, more preferably from 10 to 80% by weight of the composition, from the viewpoints of thermal resistance and moisture tolerance.

The curing agent contained in the resin composition of this embodiment is not particularly limited, as long as the agent functions as a curing agent for above-mentioned epoxy resin, and various curing agents can be used. The phenolic curing agent is generally used from the viewpoint of having excellent moisture tolerance reliability, and various acid anhydride-based curing agents, aromatic amines, dicyandiamide, hydrazide, benzoxazine cyclic compounds and the like can be also used. These curing agents can be used alone or in admixture of two or more kinds.

The phenolic curing agent includes, for instance, cresol novolak resins, phenol novolak resins, phenolic resins containing dicyclopentadiene ring, phenol aralkyl resins, naphthol, xylylenic phenol resins, silicone-modified phenol novolak resins, and the like. These phenolic curing agents can be used alone or in admixture of two or more kinds.

As to the composition ratio of the epoxy resin and the curing agent mentioned above, when the phenolic curing agent is used as a curing agent, the reactive hydroxyl group equivalent in the phenolic curing agent is preferably from 0.5 to 1.5 g/eq., more preferably from 0.7 to 1.2 g/eq., per 1 g/eq. of the epoxy equivalence in the epoxy resin, from the viewpoints of securing curability, thermal resistance and moisture tolerance reliability. Incidentally, even in a case where a curing agent other than the phenolic curing agent is used, the composition ratio is in accordance with the composition ratio (equivalence ratio) as in the case where the phenolic curing agent is used.

The silica particles contained in the resin composition of this embodiment have an average particle diameter dmax of from 3 to 50 nm, preferably 8 to 30 nm from the viewpoints of securing solderability and transparency. The silica particles have a half-width of 1.5 times or less of the average particle diameter dmax. Furthermore, those silica particles having high spherocity are preferable.

The term "average particle diameter dmax" as used herein refers to a diameter of a particle having a largest volume in a particle size distribution curve in which the volume ratio of the particle is plotted against the particle diameter when the particle size is determined by a neutron small angle scattering method. In addition, the term "half-width" refers to a width of the distribution curve positioned at a height corresponding to one-half of the peak dmax in the particle size distribution curve. The smaller the half-width, the sharper the particle size distribution. Since the silica particles having the above properties are used in the resin composition of this embodiment, a resin composition having a low viscosity can be obtained even in a comparatively higher content.

The content of the silica particles in the resin composition is preferably from 10 to 65% by weight, more preferably from 20 to 60% by weight of the composition, from the viewpoints of securing fluidity and improving connection reliability.

The resin composition of this embodiment may contain other components as mentioned below as desired.

For instance, a curing accelerator can be added to the resin composition of this embodiment as desired. The curing accelerator is not particularly limited as long as the curing accelerator serves as a curing accelerator for the above-mentioned epoxy resin. The curing accelerator includes various curing accelerators, such as amine adduct-based curing accelerators, phosphorus-containing curing accelerators, boron-containing curing accelerators, phosphorus-boron-containing curing accelerators, and the like. In addition, a microcapsulated curing accelerator in which the curing accelerator is enveloped in a microcapsule (see, for instance, JP2000-309682A) is more preferably used. These curing accelerators can be used alone or in admixture of two or more kinds.

The content of the curing accelerator in the resin composition may be appropriately set in a ratio so that the desired curing rate is obtained and that solderability and adhesiveness are not lowered. The setting method includes, for instance, a method comprising measuring the gelation time (index for curing rate) on a hot plate of the resin composition containing a curing accelerator in various amounts, whereby the amount at which the desired gelation time is obtained is defined as its content. In general, the content of the curing accelerator is preferably from 0.01 to 20 parts by weight, more preferably from 0.05 to 10 parts by weight, based on 100 parts by weight of the curing agent.

Further, a soldering aid can be added to the resin composition of this embodiment as desired. The soldering aid is not particularly limited as long as the soldering aid has been conventionally used. The soldering aid includes organic carboxylic acids such as acetic acid, adipic acid, maleic acid, fumaric acid, itaconic acid, phthalic acid, trimellitic acid, pyromellitic acid, acrylic acid, isocyanuric acid and carboxyl group-containing acrylonitrile-butadiene rubbers. An ester formed between the organic carboxylic acid and a vinyl ether compound may be also used as the soldering aid from the viewpoint of improving solderability and compatibility with the epoxy resin. The vinyl ether compound includes vinyl ethers having butyl group, ethyl group, propyl group, isopropyl group, cyclohexyl group or the like. Since the formed ester mentioned above is used as a soldering aid, the ester can exhibit its solderability function in the process of mounting a semiconductor and thereafter react with the epoxy resin. Therefore, the ester can be suitably used as a material having properties of both the soldering aid and the curing agent

The content of the soldering aid in the resin composition is preferably from 0.1 to 20% by weight, more preferably from 0.3 to 10% by weight, and even more preferably from 0.5 to 5% by weight of the composition, from the viewpoint of securing solderability and strength of the cured product.

Furthermore, for the purpose of improving adhesion, there can be further added to the resin composition of this embodiment a coupling agent such as a silane coupling agent and a titanium coupling agent, a flexibility imparting agent such as a synthetic rubber or a silicone compound, an antioxidant, a defoaming agent or the like.

The resin composition of this embodiment can be prepared, for instance, in the following manner. Specifically, first, a given amount of silica particles are dispersed in a given amount of an epoxy resin from the viewpoints of the homogeneity of the dispersion and the suppression of increase in viscosity, and thereafter the mixture is dried under reduced pressure to give a mixture of the epoxy resin and the silica particles (which may be also referred to herein as "silica-dispersed epoxy resin"). At this point, a solvent capable of forming an azeotropic compound with water may be mixed for completely dehydrating the mixture. Examples of the solvent described above include methanol, ethanol, acetone, methyl ethyl ketone, ethyl acetate and the like. The dispersion as used to herein refers to a state in which a gel-like substance derived from the aggregation of solid particles does not substantially exist in the medium.

The silica-dispersed epoxy resin includes, for instance, ones commercially available from HANSE under the trade names of "NANOPOX XP22/0543," "NANOPOX XP22/0540" and the like.

The silica-dispersed epoxy resin obtained as described above and a curing agent are mixed in given amounts, and further components other than the above are properly added as desired, and the mixture is kneaded and melt-mixed in a heating state by means of a kneader such as a universal stirring pot. Next, the mixture is filtered with a filter, and the filtrate is subsequently defoamed under reduced pressure to give the desired resin composition.

When the resin composition is prepared, an organic solvent may be added for the purpose of adjusting fluidity of the composition. The above-mentioned organic solvent includes, for instance, toluene, xylene, methyl ethyl ketone (MEK), acetone, diacetone alcohol and the like. These organic solvents may be used alone or in admixture of two or more kinds.

The resin composition of this embodiment prepared as described above has a viscosity of 5000 Pa•s or less as determined at 80°C, and the resin composition has a viscosity of preferably from 0.1 to 5000 Pa•s, more preferably from 0.1 to 3000 Pa•s, and even more preferably from 1 to 1000 Pa•s, from the viewpoint of securing solderability and coating operability.

The viscosity of the above-mentioned resin composition is determined with an E-type viscometer (commercially available from Thermo Electron Corporation, trade name: RS-1) at 80°C for 1 g of the resin composition.

Further, the cured product of the resin composition of this embodiment prepared as described above has a coefficient of linear thermal expansion of preferably 70 × 10⁻⁶/K or less, more preferably 60 × 10⁻⁶/K or less, as determined at a glass transition temperature (Tg), from the viewpoint of securing junction reliability.

The coefficient of linear thermal expansion of the above-mentioned resin composition is determined by curing the resin composition in a mold die at 170°C for 2 hours to prepare a test piece of 5 mmφ × 20 mm, and measuring the coefficient of linear thermal expansion at the temperature of Tg with MJ800GM commercially available from RIGAKU CORPORATION at a programming rate of 5°C/min.

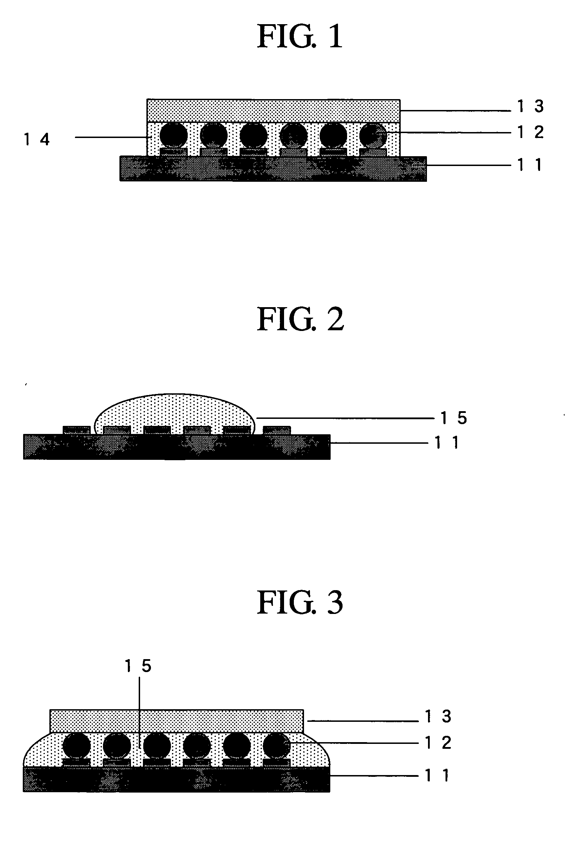

The semiconductor device manufactured by encapsulating with the resin composition of this embodiment, as shown in Figure 1, has a structure in which a semiconductor element 13 is mounted on one side of a printed circuit board 11 via plural connecting electrodes 12. Further, an encapsulating resin layer 14 is formed between the printed circuit board 11 and the semiconductor element 13.

The printed circuit board 11 is not particularly limited and is roughly divided into a ceramic board and a plastic board. The plastic board includes an epoxy board such as a glass epoxy board, a bismaleimidotriazine board, a polyimide board, and the like.

The plural connecting electrodes 12 electrically connecting the printed circuit board 11 and the semiconductor element 13 may be previously arranged on the surface of the printed circuit board 11 or on the surface of the semiconductor element 13. Further, the plural connecting electrodes 12 may be arranged on each of both the surface of the printed circuit board 11 and the surface of the semiconductor element 13.

The material for the plural connecting electrodes 12 is not particularly limited, and the material includes, for instance, low-melting point solders, high-melting point solders, tin, silver-tin and the like. Also, the material for the plural connecting electrodes 12 may be optionally gold, copper and the like in the case where the electrodes on the printed circuit board are made of the above-mentioned materials.

The semiconductor element 13 is not particularly limited, and one usually used as the semiconductor element can be used. The semiconductor element 13 includes, for instance, various semiconductors such as element semiconductors made of silicon, germanium or the like, and compound semiconductors made of gallium arsenide, indium phosphide or the like. The size of the semiconductor element 13 is usually set at a width of from 2 to 20 mm and a length of from 2 to 20 mm and a thickness of from 0.1 to 0.6 mm. In addition, the size of the printed circuit board 11 on which a printed circuit mounting the semiconductor element 13 is formed is usually set in a range of a width of from 10 to 70 mm, a length of from 10 to 70 mm and a thickness of from 0.05 to 3.0 mm so as to match the size of the semiconductor element 13. In the case of a map-type board (one in which a large number of semiconductor elements are mounted on one printed circuit board), both the width and the length of the board can be set at 40 mm or more. Also, the gap distance between the semiconductor element 13 and the printed circuit board 11, in which gap the molten resin composition is filled is usually from 5 to 100 µm.

The semiconductor device manufactured by encapsulating with the resin composition of this embodiment, as described above, can be manufactured by allowing the resin composition to exist between the printed circuit board and the semiconductor elements, and forming an encapsulating resin layer. Here, the resin composition may be applied to the printed circuit board or semiconductor elements. In the case where the resin composition is applied to the side of semiconductor elements, the resin composition can be applied to the wafer before cutting into individual chips, or the resin composition can be applied to individual chips after dicing. Since the method comprising applying a resin composition to a wafer, dicing into individual chips, and subsequently performing subjected to chip-mounting allows to resin-coat collectively at the wafer level, the method is preferable from the viewpoint of improving productivity. The method of resin coating may be either of a printing method or a spin coating method, and a printing encapsulation method utilizing vacuum differential pressure in the printing method is more preferable because air bubbles are less likely to enter the encapsulating resin layer. One example of the embodiment according to the method for manufacturing a semiconductor device of this embodiment will be described in order on the basis of the drawings.

In the embodiment in which a resin composition is applied to a printed circuit board, as shown in Figure 2, first, a resin composition 15 of this embodiment in a molten state, for instance, heated to a temperature of 60°C is subject to potting onto a printed circuit board 11. Subsequently, as shown in Figure 3, a semiconductor element 13 provided with plural spherical connecting electrodes (joint balls) 12 is placed at a given position on the resin composition. The resin composition 15 is further heated into a molten state on a heating stage, so that the connecting electrodes 12 of the semiconductor element 13 are contacted with the printed circuit board 11 while the connecting electrodes 12 push away the resin composition 15 in a molten state, and the resin composition 15 in a molten state is filled into a gap formed between the semiconductor element 13 and the printed circuit board 11. Thereafter, a metal junction is performed by solder reflow, and thereafter the resin composition is cured to form an encapsulating resin layer 14 and encapsulate the gap. The curing temperature of the resin composition is usually preferably from 130° to 200°C. At this time, the solder reflow system may be a soldering system using a reflow furnace, or a soldering system in which a heater portion is heated to a temperature of the melting point or higher of the solder simultaneously with chip mounting to perform solder melting. Thus, the semiconductor device shown in Figure 1 is manufactured.

Incidentally, the method for manufacturing a semiconductor device is described in the case where a semiconductor element 13 provided with plural spherical connecting electrodes (joint balls) 12 is used, and the method is not limited thereto. For instance, there may be used one in which plural spherical connecting electrodes 12 is previously provided on a printed circuit board 11.

The thickness and the weight of the resin composition 15 are properly set in accordance with the size of the semiconductor element 13 to be mounted and the size of connecting electrodes 12 provided on the semiconductor element 13, i.e. the volume occupied by the encapsulating resin layer 14 to be formed by filling and encapsulating the gap formed between the semiconductor element 13 and a printed circuit board 11.

In the method for manufacturing a semiconductor device, the heating temperature at which the resin composition 15 is heat-melted into a molten state is properly set in consideration of heat resistance of the semiconductor element 13 and the printed circuit board 11, the melting point of the connecting electrodes 12, softening point and heat resistance of the resin composition 15, and the like.

### Embodiment 2

The composition of the present invention can be used in a sheet-like form, and the composition of the present invention can be also applied to a wafer level flip-chip mounting system or the like. In this case, the viscosity of the composition is 10000 Pa•s or less as determined at 80°C. Therefore, the present invention can also provide a sheet-like resin composition usable for encapsulating a semiconductor, wherein said sheet-like resin composition has a viscosity of 10000 Pa•s or less as determined at 80°C, and wherein the sheet-like resin composition comprises:
(A) an epoxy resin having two or more epoxy groups in one molecule;
(B) a curing agent; and
(C) silica particles having an average particle diameter dmax of from 3 to 50 nm and a half-width of 1.5 times or less of the average particle diameter dmax.

In the wafer level flip-chip mounting system, the resin for encapsulation is fed to a patterned side of a wafer, the wafer is diced into individual semiconductor elements, and the semiconductor elements are mounted on a circuit board. In the sheet-like resin composition for encapsulating a semiconductor of this embodiment, since the silica particles have particle sizes smaller than the wavelength of light in the visible region, the sheet-like resin composition retains pattern-recognizable transmittance. Therefore, by feeding this resin composition to the patterned side, the wafer can be easily diced into individual chips, so that a semiconductor device having excellent electric connection after the encapsulation can be manufactured.

In this embodiment, the epoxy resin, the curing agent and the silica particles are the same ones as those used in Embodiment 1.

The term "transmittance" as used herein refers to the transmittance as determined by a spectrophotometer (commercially available from Shimadzu Corporation, trade name: UV3101) at a wavelength of 650 nm. The transmittance of the composition of this embodiment is not particularly limited as long as the patterns can be recognized. The transmittance is preferably 30% or more, more preferably 50% or more.

A thermoplastic resin can be added to the resin composition of this embodiment as desired. The thermoplastic resin includes, for instance, alkyl acrylate copolymers, acrylonitrile-butadiene copolymers, hydrogenated acrylonitrile-butadiene copolymers, styrene-butadiene-styrene copolymers, epoxy-modified styrene-butadiene-styrene copolymers, and the like. The content of the thermoplastic resin in the resin composition is not particularly limited as long as the resin composition can be formed into a sheet. The content of the thermoplastic resin in the composition is preferably from 1 to 50% by weight, more preferably from 3 to 30% by weight, from the viewpoint of securing adhering property to the wafer, cutting workability and chip-mounting property. These thermoplastic resins can be used alone or in admixture of two or more kinds.

Furthermore, a curing accelerator, a soldering aid or a combination of both can be added to the resin composition of this embodiment as desired in the same manner as in Embodiment 1. The curing accelerator and the soldering aid are the same one as those used in Embodiment 1.

In addition, there may be added to the resin composition of this embodiment a silane coupling agent, a titanium coupling agent, a surface-modifying agent, an antioxidant, a tackifying agent, silicone oil, a silicone rubber-reactive or synthetic rubber-reactive diluent or the like from the viewpoint of lowering stress, or there may be added thereto ion trapping agents such as hydrotalcites and bismuth hydroxide from the viewpoint of improving moisture tolerance reliability. These additives can be used alone or in admixture of two or more kinds. The content of these additives can be properly adjusted within the range so as to obtain the desired effects of each additive.

The resin composition of this embodiment can be, for instance, prepared as follows. The composition is usually formed as a sheet-like composition on a stripping sheet (for instance, a polyester film) in consideration of its convenience of use. Specifically, first, a silica-dispersed epoxy resin is obtained in the same manner as in Embodiment 1.

Next, the silica-dispersed epoxy resin, a curing agent, and optional other components are blended in a given amount, and the mixture obtained is mixed and dissolved in an organic solvent such as toluene, methyl ethyl ketone or ethyl acetate, and this mixed solution is applied to a given stripping sheet (for instance, a polyester film). Next, the sheet is subjected to a drying step at a temperature of from about 80° to about 160°C, and thereafter the organic solvent is removed, thereby preparing a sheet-like resin composition on the stripping sheet. Alternatively, the silica-dispersed epoxy resin, a curing agent, and optional other components are blended in a given amount, and the mixture obtained is mixed and dissolved in an organic solvent such as toluene, methyl ethyl ketone or ethyl acetate, and this mixed solution is applied to a substrate film such as a polyester film subjected to a releasing treatment (for instance, silicon treatment). Next, this applied substrate film is subjected to a drying step at a temperature of from about 80° to about 160°C, thereby preparing the sheet-like resin composition on the substrate film. Thereafter, the sheet-like resin composition on the substrate film is adhered to the given stripping sheet using a roll laminater, and only the substrate film is removed from the sheet, whereby preparing a sheet-like resin composition on the stripping sheet. Here, the application of the above-mentioned mixed solution to the stripping sheet or the substrate film is preferably carried out so that the film obtained has a thickness of from 10 to 200 µm.

The resin composition of this embodiment prepared as described above has a viscosity of 10000 Pa•s or less, from the viewpoint of securing solderability and fluidity during melting. The resin composition has a viscosity of preferably from 0.1 to 10000 Pa•s, more preferably from 0.1 to 5000 Pa•s, even more preferably from 1 to 3000 Pa•s, as determined at 80°C.

Here, the viscosity of the above-mentioned resin composition can be determined in the same manner as in Embodiment 1.

Further, the cured product of the resin composition of this embodiment prepared as described above has a coefficient of linear thermal expansion of preferably 70 × 10⁻⁶/K or less, more preferably 60 × 10⁻⁶/K or less, as determined at a temperature of a glass transition temperature (Tg), from the viewpoint of securing bonding reliability.

Here, the coefficient of linear thermal expansion of the above-mentioned resin composition can be determined in the same manner as in Embodiment 1.

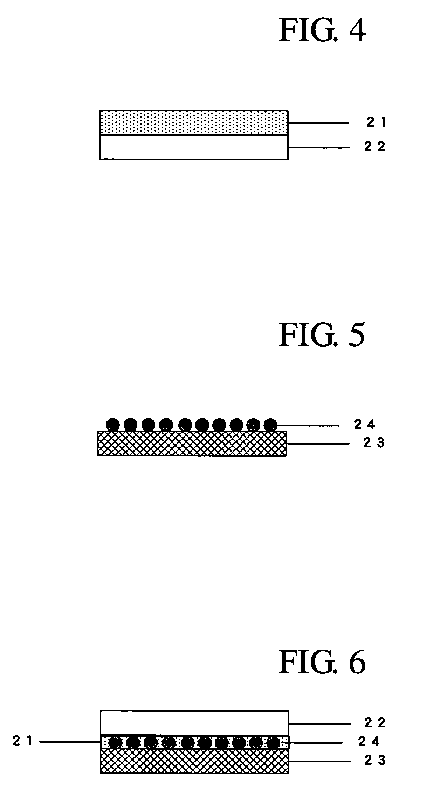

One example of the resin sheet made from the resin composition of this embodiment and the stripping sheet is shown in Figure 4. In the figure, a resin composition 21 is laminated on a stripping sheet 22.

Next, the method for manufacturing a semiconductor device of the present invention will be described. The method for manufacturing a semiconductor device of this embodiment comprises the steps of adhering a resin sheet containing the resin composition of this embodiment to the semiconductor circuit side, optionally grinding a backside of a bump-mounting wafer to which the resin sheet is adhered, removing (stripping) a stripping sheet leaving only the resin composition to the wafer, and cutting the wafer into individual chips. Figures 5 to 9 each shows one example of each step in the method for manufacturing a semiconductor device of this embodiment. The method for manufacturing a semiconductor device of this embodiment will be explained hereinbelow by referring to these drawings.

One example of the bump-mounting wafer is shown in Figure 5, wherein a bump 24 is formed on a wafer 23.

The materials of the wafer 23 usable in this embodiment include, but not particularly limited to, silicon, gallium-arsenic and the like.

The bump 24 includes, for instance, but not particularly limited to, low-melting point and high-melting point bumps obtained by soldering, tin bumps, silver-tin bumps, silver-tin-copper bumps, gold bumps, copper bumps and the like.

One example in which the resin sheet (illustrated in Figure 4) is adhered to the semiconductor circuit side of the above-mentioned wafer 23 is shown in Figure 6, wherein the semiconductor circuit side of the wafer 23 and the resin composition 21 are contacted with each other, and the bump 24 is embedded in the resin composition 21.

In the adhesion of the resin sheet to the above-mentioned wafer 23, the roller-type adhering device and a vacuum-type adhering device is used. The adhering temperature is preferably from 25° to 100°C, more preferably from 40° to 80°C, from the viewpoints of reduction of voids, improvement in close contact of the wafer, and prevention of bowing of the wafer after grinding. In addition, the adhering pressure is appropriately set depending upon the adhering method, the adhering time and the like.

The wafer to which the above-mentioned resin sheet is adhered may be subjected to grinding to obtain the desired thickness. In the grinding of the wafer, the grinding device having a grinding stage is used without particular limitation. The grinding device includes a known device such as "DFG-840" commercially available from DISCO K.K. Also, the grinding conditions are not particularly limited.

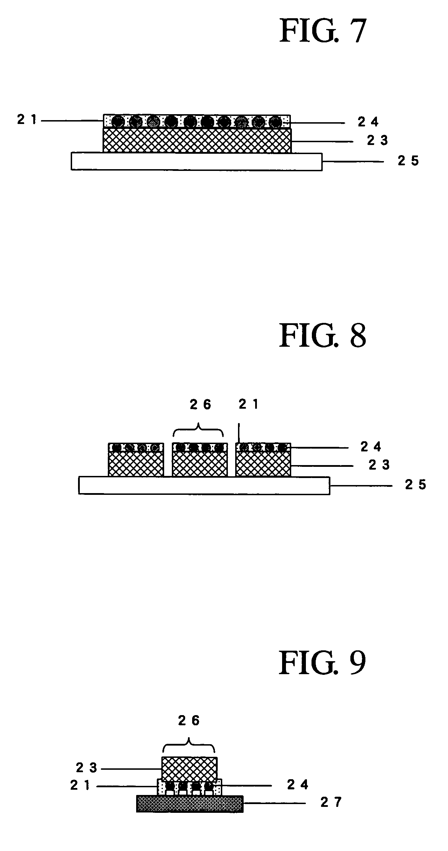

One example where a dicing tape is adhered to a backside or grinding side of the wafer after grinding is shown in Figure 7, wherein only a stripping sheet 22 is removed from the resin sheet, and a dicing tape 25 is adhered to a backside of the wafer 23.

The removal of the stripping sheet 22 is carried out by using, for instance, "HR-8500-II" commercially available from Nitto Denko Co., Ltd.

The dicing tape 25 usable in this embodiment is not particularly limited, as long as the dicing tape is one which is usually used in the field of art.

The devices and conditions for adhering the dicing tape 25 are not particularly limited, and known devices and conditions can be employed.

One example after cutting (dicing) of the wafer is shown in Figure 8, wherein the wafer 23 to which the resin composition 21 is adhered is cut into individual chips 26 with keeping the wafer 23 adhered to the dicing tape 25.

The cutting of the wafer is not particularly limited, and cutting is carried out with an ordinary dicing device.

One example after mounting the chips is shown in Figure 9, wherein the individual chips 26 are removed from the dicing tape, and mounted on a printed circuit board 27. The gap formed between the wafer 23 and the printed circuit board 27 is resin-encapsulated by the resin composition.

The printed circuit board 27 is the same one used in Embodiment 1.

The method for mounting individual chips 26 on a printed circuit board 27 includes a method comprising firstly picking up and removing the individual chips 26 from a dicing tape 25, and housing the individual chips in a chip tray or conveying the individual chips 26 to a chip-mounting nozzle of a flip-chip bonder; and thereafter (i) obtaining electric connection at the same time as mounting the individual chips 26 to the printed circuit board 27, while pressing with heating in a bump-bonding form; (ii) obtaining an electric connection at the same time as mounting the individual chips 26 to a printed circuit board 27 using heat, pressure and ultrasonication; (iii) mounting the individual chips 26 to a printed circuit board 27, and thereafter obtaining electric connection by solder reflow; and the like.

The above-mentioned heating temperature is preferably 500°C or lower, more preferably 400°C or lower, from the viewpoint of preventing deterioration of the individual chips 26 and the printed circuit board 27. The lower limit of the heating temperature is about 100°C. Although the above-mentioned pressure conditions depend on the number of connecting electrodes or the like, the pressure is preferably from 9.8 × 10⁻³ to 1.96 N/bump, more preferably from 1.96 × 10⁻² to 9.8 × 10⁻¹ N/bump.

According to the above method, a semiconductor device having excellent electric connection reliability can be efficiently obtained. The semiconductor device obtained is encompassed in this embodiment.

### EXAMPLES

The present invention will be described more specifically hereinbelow by means of Examples, without intending to limit the present invention thereto.

The raw materials used in Examples 1-1 to 1-4 and Comparative Examples 1-1 to 1-4 are collectively shown hereinbelow.
(1) Epoxy Resin
   As an epoxy resin,
   (a) a bisphenol A epoxy resin (epoxy equivalence: 185 g/eq.), or
   (b) a bisphenol F epoxy resin (epoxy equivalence: 158 g/eq.)
   was used.
(2) Curing Agent
   As a curing agent, a xylylenic phenolic resin (hydroxyl equivalence: 174 g/eq.) was used.
(3) Curing Accelerator
   As a curing accelerator, a microcapsulated triphenylphosphine (shell: polyurea, core/shell ratio= 20/80% by weight) was used.
(4) Soldering Aid
   As a soldering aid, a carboxy-modified acrylonitrile-butadiene copolymer (Mooney viscosity: 45 ML (1+4), acrylonitrile content: 27% by weight, carboxyl group content: 0.027 ephr, corresponding to carboxyl group equivalence: 3700 g/eq.) was used.
(6) Silica-Dispersed Epoxy Resin
   As a silica-dispersed epoxy resin,
   (a) a silica-dispersed epoxy resin (epoxy resin: bisphenol A epoxy resin; silica particle diameter: average particle diameter dmax = 15 nm, maximum particle diameter = 40 nm, half-width = 10 nm; silica content = 50% by weight; epoxy equivalent = 380 g/eq.; commercially available from Hanse Chemie AG, trade name: "NANOPOX XP22/0543") or
   (b) a silica-dispersed epoxy resin (epoxy resin: bisphenol F epoxy resin; silica particle diameter: average particle diameter dmax = 15 nm, maximum particle diameter = 40 nm, half-width = 10 nm; silica content = 60% by weight; epoxy equivalent = 425 g/eq.; commercially available from Hanse Chemie AG, the trade name: "NANOPOX XP22/0540")
   was used.
(7) Silica Particles
   As silica particles,
   (a) a silica-dispersed solution (average particle diameter dmax = 12 nm, maximum particle diameter = 40 nm, half-width = 20 nm, solvent: methyl ethyl ketone, silica content: 12% by weight, commercially available from FUSO CHEMICAL CO., LTD., trade name: "PL-1") or
   (b) a silica-dispersed solution [one prepared by dispersing in a methyl ethyl ketone solvent silica particles (average particle diameter dmax = 300 nm, maximum particle diameter = 350 nm, half-width = 50 nm, commercially available from NIPPON SHOKUBAI CO., LTD., "KE-S30") with a beads-mill commercially available from ASADA IRON WORKS. CO., LTD. (materials of beads: zirconia, particle diameter = 1 mm) at a rotational speed of 3000 rpm for 60 minutes, silica content: 50% by weight] was used.

The evaluation methods for Examples 1-1 to 1-4 and Comparative Examples 1-1 to 1-4 are summarized hereinbelow.
(1) Viscosity
   The viscosity of 1 g of a resin composition was determined at 80°C with an E-type viscometer (commercially available from Thermo Electron Corporation, trade name: "RS-1") for which the diameter of the plate was set at 35 mm, the gap at 100 µm, and the rotational speed at 10 (1/s). Since the detection limit of the E-type viscometer is 10000 Pa•s, a viscosity of equal to or greater than the detection limit cannot be determined.
(2) Coefficient of Linear Thermal Expansion
   A resin composition was cured in a mold die at a temperature of 170°C for 2 hours and made into a test piece of 5 mmφ × 20 mm. The coefficient of linear thermal expansion of the test piece was determined at a temperature of Tg or less at a programming rate of 5°C/minute with one commercially available from RIGAKU CORPORATION, trade name: "MJ800GM."
(3) Initial Electric Conductivity Test
   The electric resistance of the semiconductor device was determined with daisy chain (digital multimeter "TR6847" commercially available from ADVANTEST), and those without indication of the electric resistance of a semiconductor device were counted as defective products.
(4) Thermal Shock Test
   A procedure of keeping the semiconductor device at -55°C for 5 minutes, and thereafter keeping the semiconductor device at 125°C for 5 minutes was carried out for 500 times (TST 500 cycles) or 1000 times (TST 1000 cycles). Thereafter, the electric resistance of the semiconductor device was determined with a daisy chain (commercially available from ADVANTEST, trade name: DIGITAL MULTIMETER TR6847). The obtained electric resistance was compared to the initial value (electric resistance of the semiconductor device before carrying out the above-mentioned procedure). Those semiconductor devices of which electric resistances are twice or more of the initial value were counted as defective products.

### Examples 1-1 to 1-4 and Comparative Examples 1-1 to 1-4

The resin compositions of Examples 1-1 to 1-4 and Comparative Examples 1-1 to 1-4 were prepared as follows.

Each of the raw materials shown in Tables 1 and 2 was mixed in the proportion shown in the tables with an ultra-high speed mixing system (T. K. ROBOMICS Model B, commercially available from TOKUSHU KIKA KOGYO CO., LTD.) at room temperature and 1000 rpm for 30 minutes. Next, the obtained mixture was filtered with a 400-mesh filter (width of opening: 0.038 mm) at room temperature. Thereafter, in order to remove the solvent and air bubbles in the filtrate, the mixture was concentrated under reduced pressure of 0.0026 MPa at a temperature of 90°C for 60 minutes to give a resin composition. The properties of the resin composition, specifically viscosity and coefficient of linear thermal expansion, were determined. The values are shown in Tables 1 and 2.

**Table 1**

| (parts by weight) | | | | |
|---|---|---|---|---|
| | Example Nos. | | | |
| | 1-1 | 1-2 | 1-3 | 1-4 |
| Silica-Dispersed (a) | 31.55 | - | 31.55 | - |
| Epoxy Resin (b) | - | 32.64 | - | 32.64 |
| Curing Agent | 14.55 | 13.36 | 14.55 | 10.69 |
| Curing Accelerator | 0.31 | 0.27 | 0.31 | 0.29 |
| Soldering Aid | 0.95 | 0.83 | 0.95 | 0.88 |
| Methyl Ethyl Ketone | 20.3 | 20.2 | 19.9 | 19 |
| Viscosity (Pa•s) | 800 | 2800 | 190 | 4600 |
| Coefficient of Linear Thermal Expansion (× 10⁻⁶/K) | 59 | 55 | 50 | 46 |

**Table 2**

| (parts by weight) | | | | |
|---|---|---|---|---|
| | Comparative Example Nos. | | | |
| | 1-1 | 1-2 | 1-3 | 1-4 |
| Epoxy Resin (a) | 20 | 20 | 20 | - |
| (b) | - | - | - | 20 |
| Silica-Dispersed (a) | - | 168 | - | 196.3 |
| Solution (b) | - | - | 40.32 | - |
| Curing Agent | 18.81 | 18.81 | 18.81 | 22.75 |
| Curing Accelerator | 0.39 | 0.39 | 0.39 | 0.43 |
| Soldering Aid | 1.21 | 1.21 | 1.21 | 1.34 |
| Viscosity (Pa•s) | 12 | * | 21 | * |
| Coefficient of Linear Thermal Expansion (× 10⁻⁶/K) | 72 | 60 | 58 | 54 |

| | | | | |
|---|---|---|---|---|
| Note *: The viscosity was too high so that the viscosity was undeterminable with an E-type viscometer. | | | | |

A semiconductor device (equivalent to a semiconductor device shown in Figure 1) was manufactured by using the resin composition prepared above in accordance with the above-mentioned method for manufacturing a semiconductor device. Specifically, a resin composition heated to a temperature of 80°C in a molten state was subjected to potting on a printed circuit board (thickness of a glass epoxy board: 0.8 mm). The potted printed circuit board was placed on a stage heated to a temperature of 100°C, and a semiconductor element (thickness: 600 µm, size: 10 mm × 10 mm) provided with connecting electrodes (eutectic solder: melting point: 183°C, height of electrode: 80 µm, number of electrodes: 2000) was subjected to chip mounting (temperature = 100°C, pressure = 1 g/bump (9.8 × 10⁻³ N/bump), time = 1 second) in a given position on the resin composition with a flip chip bonder (commercially available from Panasonic Factory Solutions Co., Ltd., trade name: FB30T-M). By the chip mounting, the resin in a molten state was filled into a gap between the printed circuit board and the semiconductor element. Thereafter, the soldering was carried out under the following JEDEC condition with a solder-reflow furnace (commercially available from JARD, Inc., trade name: MJ-R4000) to provide an electric connection. IPC/JEDEC J-STD-20C, reflow condition for Sn-Pb was used. The temperature profile was as follows: Ramping up for preheat from 25° to 100°C in 60 seconds, keeping the temperature for flux activation between 100° and 150°C for 90 seconds, following ramping up to 240°C by an averaging rate of 2°C/second, keeping within 5°C of actual peak temperature 240°C for 15 seconds, and finally ramping down cooling by less than 6°C/second. The time maintained above 183°C (solder melting temperature) was 90 seconds. The resin was then cured in the oven (PHH-100, commercially available from ESPEC Corporation) at a temperature of 170°C for 120 minutes to manufacture an intended semiconductor device. The semiconductor device obtained was evaluated as described above. The results are shown in Tables 3 and 4.

**Table 3**

| | Example Nos. | | | |
|---|---|---|---|---|
| | 1-1 | 1-2 | 1-3 | 1-4 |
| Initial Electric | 0/10 | 0/10 | 0/10 | 0/10 |
| Conductivity | | | | |
| TST500 | 0/10 | 0/10 | 0/10 | 0/10 |
| TST1000 | 0/10 | 0/10 | 0/10 | 0/10 |

**Table 4**

| | Comparative Example Nos. | | | |
|---|---|---|---|---|
| | 1-1 | 1-2 | 1-3 | 1-4 |
| Initial Electric | 0/10 | 10/10 | 10/10 | 10/10 |
| Conductivity | | | | |
| TST500 | 1/10 | * | * | * |
| TST1000 | 4/10 | * | * | * |

| | | | | |
|---|---|---|---|---|
| Note *: Since the electric resistance was not indicated from immediately after the manufacture of the semiconductor, the evaluation could not be made. | | | | |

It was confirmed from the results in Tables 3 and 4 that since the semiconductor elements of Examples secure superior solderability, operability and connection reliability as compared to the semiconductor elements of Comparative Examples because the semiconductor elements of Examples contain silica particles having a specified particle diameter, and further a resin composition having a viscosity is 5000 Pa•s or less as determined at a temperature of 80°C.

The raw materials and parts used in Examples 2-1 to 2-5 and Comparative Examples 2-1 to 2-6 are collectively shown hereinbelow.
(1) Epoxy Resin
   The same epoxy resins as those in Examples 1-1 to 1-4 and Comparative Examples 1-1 to 1-4 were used.
(2) Curing Agent
   As a curing agent,
   (a) a xylylenic phenolic resin (hydroxyl equivalence: 174 g/eq.), or
   (b) a silicone-modified phenol novolak resin (hydroxyl equivalence: 137 g/eq.)
   was used.
(3) Curing Accelerator
   As a curing accelerator,
   (a) a microcapsulated triphenylphosphine (shell: polyurea, core/shell ratio = 50/50% by weight), or
   (b) a microcapsulated triphenylphosphine (shell: polyurea, core/shell ratio = 20/80% by weight)
   was used.
(4) Thermoplastic Resin
   As a thermoplastic resin, acrylonitrile-butadiene rubber (Mooney viscosity: 50ML(1+4), amount of acrylonitrile bonded = 30% by weight) was used.
(5) Soldering Aid
   As a soldering aid, an adipic acid-cyclohexanedimethanol divinyl ether polymer (acid equivalent: 269 g/mol, molecular weight (Mn) =1100) was used.
(6) Silica-Dispersed Epoxy Resin
   The same silica-dispersed epoxy resins as those in Examples 1-1 to 1-4 and Comparative Examples 1-1 to 1-4 were used.
(7) Silica Particles
   The same silica particles as those in Examples 1-1 to 1-4 and Comparative Examples 1-1 to 1-4 were used.
(8) Wafer
   As a wafer,
   (a) a wafer provided with gold stud bumps (material: silicon, 8 inch (203.2 mm), chip size: 10 mm², number of bumps: 250 pins/chip), or
   (b) a wafer provided with eutectic solder (Sn-37Pb, melting point: 183°C) bumps (material: silicon, 8 inch (203.2 mm), chip size: 10 mm², number of bumps: 2000 pins/chip)
   was used.

The evaluation methods for Examples 2-1 to 2-5 and Comparative Examples 2-1 to 2-6 are collectively shown hereinbelow.
(1) Transmittance
   Transmittance of the resin composition was determined with a spectrophotometer (commercially available from Shimadzu Corporation, trade name: UV3101) at a wavelength of 650 nm. Here, the case where the transmittance is 30% or more was evaluated as "pattern-recognizable."
(2) Viscosity
   The viscosity was evaluated in the same manner as in Examples 1-1 to 1-4 and Comparative Examples 1-1 to 1-4.
(3) Coefficient of Linear Thermal Expansion
   The coefficient of linear thermal expansion was evaluated in the same manner as in Examples 1-1 to 1-4 and Comparative Examples 1-1 to 1-4.
(4) Wafer Workability
   The wafer workability was evaluated by whether or not individual chips in which a resin composition is laminated could be produced.
   Evaluation Criteria
   those capable of producing such individual chips: O
   those incapable of producing such individual chips: ×
(5) Initial Electric Conductivity Test
   The initial electric conductivity test was evaluated in the same manner as in Examples 1-1 to 1-4 and Comparative Examples 1-1 to 1-4.
(6) Thermal Shock Test

A procedure of keeping the semiconductor device at -55°C for 10 minutes, and thereafter keeping the semiconductor device at 125°C for 10 minutes was carried out for 500 times (TST 500 cycles) or 1000 times (TST 1000 cycles). Thereafter, the electric resistance of the semiconductor device was determined with a daisy chain (commercially available from ADVANTEST, trade name: DIGITAL MULTIMETER TR6847). The obtained electric resistance was compared to the initial value (electric resistance of the semiconductor device before carrying out the above-mentioned procedure). Those semiconductor devices of which electric resistances are twice or more of the initial value were counted as defective products.

### Examples 2-1 to 2-5 and Comparative Examples 2-1 to 2-6

The resin compositions of Examples 2-1 to 2-5 and Comparative Examples 2-1 to 2-6 were prepared as follows.

Each of the raw materials shown in Tables 5 and 6 was dissolved in methyl ethyl ketone in the proportion shown in the tables while mixing, and this mixed solution was applied to a polyester film previously subjected to a releasing treatment. Next, the solution on the polyester film was dried at 120°C for 5 minutes to remove methyl ethyl ketone, to prepare a resin composition having a desired thickness of 50 µm. The properties of the resin composition, specifically viscosity, transmittance and coefficient of linear thermal expansion, were determined. The values are shown in Tables 5 and 6.

**Table 5**

| (parts by weight) | | | | | |
|---|---|---|---|---|---|
| | Example Nos. | | | | |
| | 2-1 | 2-2 | 2-3 | 2-4 | 2-5 |
| Silica-Dispersed (a) | 28.8 | - | 59.2 | 59.2 | - |
| Epoxy Resin (b) | - | 29.8 | - | - | 62 |
| Curing Agent (a) | 13.2 | 12.2 | - | - | - |
| (b) | - | - | 20 | 20 | 20 |
| Curing (a) | 2 | 2 | - | - | - |
| Accelerator (b) | - | - | 0.67 | 0.67 | 0.67 |
| Thermoplastic Resin | 6 | 6 | 1.55 | 1.64 | 1.48 |
| Soldering Aid | - | - | - | 2.65 | 2.39 |
| Methyl Ethyl Ketone | 50 | 50 | 35 | 36 | 37 |
| Viscosity (Pa•s) | 2500 | 4000 | 1100 | 1300 | 4600 |
| Transmittance (%) | 64 | 66 | 60 | 60 | 57 |
| Coefficient of Linear Thermal Expansion (× 10⁻⁶/K) | 69 | 66 | 59 | 60 | 57 |

**Table 6**

| (parts by weight) | | | | | | |
|---|---|---|---|---|---|---|
| | Comparative Example Nos. | | | | | |
| | 2-1 | 2-2 | 2-3 | 2-4 | 2-5 | 2-6 |
| Epoxy Resin (a) | 20 | 20 | 20 | - | 20 | 20 |
| (b) | - | - | - | 20 | - | - |
| Silica-Dispersed (a) | - | 154.8 | - | 230.6 | 185.9 | - |
| Solution (b) | - | - | 37.2 | - | - | 44.6 |
| Curing Agent (a) | 18.8 | 18.8 | 18.8 | 22 | - | - |
| (b) | - | - | - | - | 17.4 | 17.4 |
| Curing (a) | 1.62 | 1.62 | 1.62 | 1.75 | - | - |
| Accelerator (b) | - | - | - | - | 0.5 0.5 | |
| Thermoplastic Resin | 5.51 | 5.51 | 5.51 | 5.97 | 1.23 | 1.23 |
| Soldering Aid | - | - | - | - | 2 | 2 |
| Methyl Ethyl Ketone | 31 | - | 25 | - | - | 20 |
| Viscosity (Pa•s) | 90 | * | 800 | * | * | 950 |
| Transmittance (%) | 91 | 66 | 8 | 66 | 60 | 6 |
| Coefficient of Linear Thermal Expansion (× 10⁻⁶/K) | 78 | 68 | 68 | 61 | 55 | 55 |

| | | | | | | |
|---|---|---|---|---|---|---|
| Note *: The viscosity was too high so that the viscosity was undeterminable with an E-type viscometer. | | | | | | |

The resin composition prepared above was adhered to ethyl vinyl acetate (stripping sheet, 135 µm) at 80°C, to form a resin sheet. This resin sheet was adhered to a semiconductor circuit board side of the bump-mounting wafer with a roller adhering apparatus (commercially available from Nitto Denko Co., Ltd., trade name: DR-8500-II) at 70°C. A dicing tape (commercially available from Nitto Denko Co., Ltd., trade name: DU-300) was adhered to the wafer obtained. Next, the stripping sheet was removed, and thereafter the wafer obtained was cut into individual chips with a dicing apparatus (commercially available from DISCO, trade name: DFD-651), to give a chip with the resin composition.

Subsequently, the desired semiconductor devices were produced in accordance with the method described in the following (1) or (2). The semiconductor device obtained was evaluated as above. The results are shown in Tables 7 and 8.
(1) Semiconductor devices were produced by mounting chips with the resin composition to a printed circuit board (thickness of glass epoxy board: 1 mm) using a flip chip bonder (commercially available from Panasonic Factory Solutions Co., Ltd., trade name: FB30T-M) according to heat-and-pressure mounting method (upon chip mounting: temperature = 120°C, pressure = 9.8 × 10⁻² N/bump, time = 3 seconds; during actual pressing: temperature = 240°C, pressure = 4.9 × 10⁻¹ N/bump, time = 10 seconds), and carrying out resin encapsulation. The semiconductor devices obtained were subjected to post-curing of the resin composition using a drying furnace (commercially available from ESPEC Corp., trade name: PHH-100) at 150°C for 60 minutes, to give the desired semiconductor devices.
(2) Chips with the resin composition were tentatively mounted to a printed circuit board (thickness of glass epoxy board: 1 mm) using a flip chip bonder (commercially available from Panasonic Factory Solutions Co., Ltd., trade name: FB30T-M) (upon mounting chips: temperature = 120°C, pressure = 9.8 × 10⁻³ N/bump, time = 3 seconds), and at the same time resin encapsulation was carried out. Thereafter, the assembly was heated for soldering at 220°C for 10 seconds using FB30T-M to give a semiconductor device. The semiconductor device obtained was subjected to post-curing of the resin composition using a drying furnace (commercially available from ESPEC Corp., trade name: PHH-100) at 170°C for 120 minutes, to give the desired semiconductor device.

**Table 7**

| | Example Nos. | | | | |
|---|---|---|---|---|---|
| | 2-1 | 2-2 | 2-3 | 2-4 | 2-5 |
| Wafer | (a) | (a) | (b) | (b) | (b) |
| Production Method | (1) | (1) | (2) | (2) | (2) |
| Wafer Workability | O | O | O | O | O |
| Initial Electric Conductivity | 0/10 | 0/10 | 0/10 | 0/10 | 0/10 |
| TST500 | 0/10 | 0/10 | 0/10 | 0/10 | 0/10 |
| TST1000 | 0/10 | 0/10 | 0/10 | 0/10 | 0/10 |

**Table 8**

| | Comparative Example Nos. | | | | | |
|---|---|---|---|---|---|---|
| | 2-1 | 2-2 | 2-3 | 2-4 | 2-5 | 2-6 |
| Wafer | (a) | (a) | (a) | (a) | (b) | (b) |
| Production Method | (1) | (1) | (1) | (1) | (2) | (2) |
| Wafer Workability | O | × | × | × | × | × |
| Initial Electric | 0/10 | * | * | * | * | * |
| Conductivity | | | | | | |
| TST500 | 4/10 | * | * | * | * | * |
| TST1000 | 7/10 | * | * | * | * | * |

| | | | | | | |
|---|---|---|---|---|---|---|
| Note *: Since the desired chips with the resin composition were not obtained, the evaluation could not be made. | | | | | | |

As is seen from the results of Tables 5 and 7, the resin compositions prepared in Examples 2-1 to 2-5 retained pattern-recognizable transmittance, had low viscosities, so that the desired chips with the resin compositions could be produced. In addition, it can be seen that the semiconductor devices produced in Examples 2-1 to 2-5 did not cause failure in the initial electric conductivity, TST500, and TST1000.

By contrast, the resin composition prepared in Comparative Example 2-1 had a high transmittance and a low viscosity, so that a chip with the resin composition could be obtained. Since the resin composition has a high coefficient of linear thermal expansion, the semiconductor device produced therefrom caused failure in TST500 and TST1000. In addition, since the resin compositions prepared in Comparative Examples 2-2, 2-4 and 2-5 had high viscosities and little fluidity, the adhesion to the wafer at a given temperature could not be made, so that the chips with the resin composition could not be obtained. In addition, since the resin compositions prepared in Comparative Examples 2-3 and 2-5 had low transmittances that were not pattern-recognizable, the chips with the resin composition could not be obtained.

Therefore, the semiconductor devices produced in Examples 2-1 to 2-5 retained pattern-recognizable transmittance, had fluidity capable of adhering to the wafer, and secured stable electric resistance in a thermal shock test, i.e. the semiconductor devices are excellent in electric connection reliability.

The resin composition for encapsulating a semiconductor of the present invention can be utilized in encapsulating a gap formed between a printed circuit board and a semiconductor element in the semiconductor industries.

The present invention being thus described, it will be obvious that the same may be varied in many ways. Such variations are not to be regarded as a departure from the spirit and scope of the invention, and all such modifications as would be obvious to one skilled in the art are intended to be included within the scope of the following claims.

## Claims

1. A resin composition usable for encapsulating a semiconductor, wherein said resin composition has a viscosity of 5000 Pa•s or less as determined at 80°C, and wherein said resin composition comprises:
(A) an epoxy resin having two or more epoxy groups in one molecule;
(B) a curing agent; and
(C) silica particles having an average particle diameter dmax of from 3 to 50 nm and a half-width of 1.5 times or less of the average particle diameter dmax.

2. The resin composition according to claim 1, wherein said silica particles (C) are dispersed in said epoxy resin (A).

3. The resin composition according to claim 1, wherein a cured product of the resin composition has a coefficient of linear thermal expansion of 70 × 10⁻⁶/K or less as determined at a temperature of Tg.

4. A sheet-like resin composition usable for encapsulating a semiconductor, wherein said sheet-like resin composition has a viscosity of 10000 Pa**•**s or less as determined at 80°C, and wherein said sheet-like resin composition comprises:
(A) an epoxy resin having two or more epoxy groups in one molecule;
(B) a curing agent; and
(C) silica particles having an average particle diameter dmax of from 3 to 50 nm and a half-width of 1.5 times or less of the average particle diameter dmax.

5. The sheet-like resin composition according to claim 4, wherein said silica particles (C) are dispersed in said epoxy resin (A).

6. The sheet-like resin composition according to claim 4, wherein said sheet-like resin composition has a transmittance of 30% or more at a wavelength of 650 nm.

7. The sheet-like resin composition according to claim 4, wherein a cured product of the sheet-like resin composition has a coefficient of linear thermal expansion of 70 × 10⁻⁶/K or less as determined at a temperature of Tg.

8. A semiconductor device manufactured by encapsulating a semiconductor with the resin composition as defined in any one of claims 1 to 7.
